# EUROPÄISCHE PATENTSCHRIFT

(11) **EP 0 377 874 B1**
(45) Veröffentlichungstag und Bekanntmachung des Hinweises auf die Patenterteilung: **05.05.1993**
(21) Anmeldenummer: 89123578.0
(22) Anmeldetag: 20.12.1989
(51) Int. Cl.: B23K 3/04

(54) **Lötvorrichtung mit mindestens einer Bügelelektrode und zwei einander gegenüberliegenden Lötstegen oder vier paarweise einander gegenüberliegenden Lötstegen**
Soldering device with at least one stirrup electrode and two opposite soldering bridges or four by pairs opposite soldering bridges
Dispositif de soudage avec au moins une électrode à étrier et deux ponts de soudage multuellement opposés ou quatre ponts de soudage mutuellement opposés par paires

(30) Priorität: 10.01.1989 DE 3900520
(43) Veröffentlichungstag der Anmeldung: 18.07.1990
(73) Patentinhaber: SIEMENS AKTIENGESELLSCHAFT, 80333 München (DE)
(72) Erfinder: Schuster, Rudolf, D-8011 Heimstetten (DE); Raschke, Josef, D-8011 Gelting (DE); Kamperdicks, Klaus, D-8000 München 82 (DE)

(56) Entgegenhaltungen:
- DE-A- 3 149 236
- IBM TECHNICAL DISCLOSURE BULLETIN. vol. 11, no. 8, Januar 1969, NEW YORK US Seite 1026 N.F. JENSEN: "Self - leveling soldering tool"

## Beschreibung

Lötvorrichtung mit mindestens einer Bügelelektrode und zwei einander gegenüberliegenden Lötstegen oder vier paarweise einander gegenüberliegenden Lötstegen

Die Erfindung betrifft eine Lötvorrichtung mit mindestens einer an einem Lötbügelhalter befestigten und durch elektrische Widerstandswärme erhitzbaren Bügelelektrode und zwei einander gegenüberliegenden Lötstegen oder vier paarweise einander gegenüberliegenden Lötstegen, deren Arbeitsflächen in einer Ebene liegen.

Eine derartige Lötvorrichtung ist beispielsweise aus der DE-A-31 49 236 bekannt. Der Elektrodenhalter dieser bekannten Lötvorrichtung umfaßt elektrisch voneinander isolierte, kleine Säulen aus leitfähigem Material, zwischen deren Enden in auswechselbarer Weise mindestens zwei Bügelelektroden befestigt sind. Die U-förmigen Bügelelektroden, die durch elektrische Widerstandswärme erhitzt werden können, sind aus einer ebenen Platte aus einem Widerstandsmaterial wie Tantal oder Molybdän hergestellt und in der Weise angebracht, daß sie mit ihren auf der Unterseite der Lötstege liegenden Arbeitsflächen in Kontakt mit den zu verlötenden Elementen kommen. Bei einer Anzahl von zwei oder vier Bügelelektroden werden für die Elektrodenhalter insgesamt vier kleine Säulen benötigt, die auf einer jeweiligen Diagonalen des Querschnitts der Lötvorrichtung angeordnet sind und durch mehrere kreuzförmige Verstrebungen mechanisch miteinander verbunden sind. Zur Stromversorgung von vier Bügelelektroden werden zwei auf einer Diagonale liegende kleine Säulen mit dem einen Pol einer Stromquelle verbunden, während die beiden anderen kleinen Säulen mit dem anderen Pol der Stromquelle verbunden werden.

Aus der DE-A-28 18 958 ist eine andere Lötvorrichtung bekannt, bei welcher der Elektrodenhalter zwei elektrisch voneinander isolierte kleine Säulen aus leitfähigem Material umfaßt, zwischen deren Enden eine einzige Bügelelektrode in auswechselbarer Weise befestigt ist. Diese Bügelelektrode besitzt ebenfalls vier paarweise einander gegenüberliegende Lötstege, deren Arbeitsflächen die Form eines einstückigen, rechteckförmigen Rahmens aufweisen, wobei zwei einander gegenüberliegende Lötstege über nach oben ragende Fortsätze an den zugeordneten kleinen Säulen auswechselbar befestigt sind.

Aus der EP-A-0 011 046 ist eine weitere Lötvorrichtung bekannt, bei welcher eine einzige an einem Elektrodenhalter befestigte Bügelelektrode insgesamt vier paarweise einander gegenüberliegende Lötstege besitzt, deren Arbeitsflächen die Form eines einstückigen, rechteckförmigen Rahmens aufweisen. Hier ist jedoch jedem der Lötstege ein nach oben ragender Fortsatz zugeordnet, welcher die Lötstege hält und als Stromzuführung dient. Dabei liegen einander gegenüberliegende Fortsätze elektrisch parallel zueinander.

Die vorstehend geschilderten bekannten Lötvorrichtungen werden insbesondere für das Auflöten hochpoliger elektronischer Bauelemente wie Mikropacks, Flatpacks und dergleichen auf Leiterplatten eingesetzt, wobei die Widerstandserwärmung der Bügelelektroden durch Stromimpulse vorgenommen wird. Dabei muß sowohl vor dem Lötvorgang als auch während der gesamten Dauer des Lötvorganges ein sicherer Kontakt zwischen den Arbeitsflächen der Bügelelektroden, den Anschlußbeinchen der Bauelemente und den Leiterbahnen bzw. Anschlußpads der Leiterplatten gewährleistet sein. Diese Forderung kann jedoch im Hinblick auf gegebenenfalls auftretende Wölbungen der Leiterplatten, auf Toleranzen der Leiterplatten in der zur Leiterplattenebene senkrechten Richtung, auf Schichtdickentoleranzen und auf eine mögliche Schiefstellung der Leiterplatten beim Lötprozeß nicht immer erfüllt werden.

Aus IBM Technical Disclosure Bulletin, Vol. 11, No. 8, Januar 1969, New York US, Seite 1026 ist eine Lötvorrichtung mit vier an einem Halter befestigten Elektroden bekannt, die aus einem keramischen Material bestehen und durch eingebettete Widerstandsdrähte elektrisch erhitzt werden. Die Arbeitsflächen der vier paarweise einander gegenüberliegenden Elektroden liegen in einer Ebene, so daß auch mit dieser bekannten Vorrichtung hochpolige elektronische Bauelemente auf Leiterplatten aufgelötet werden können. Um geringfügige Unregelmäßigkeiten auf der Lötfläche einer Leiterplatte ausgleichen zu können, ist der Halter mit den vier Elektroden über ein Kugelgelenk an einem darüber angeordneten Gehäuse befestigt, wobei die Rückstellung in die Normallage durch vier symmetrisch zwischen Halter und Gehäuse angeordnete Federn bewerkstelligt wird.

Der Erfindung liegt daher die Aufgabe zugrunde, eine Lötvorrichtung der eingangs genannten Art so zu verbessern, daß vor dem Lötvorgang und während des Lötvorganges mit Sicherheit ein ausreichender Kontakt zwischen den Arbeitsflächen der Lötstege, den Anschlußbeinchen der Bauelemente und den Leiterbahnen bzw. Anschlußpads der Leiterplatten gewährleistet ist.

Die Lösung dieser Aufgabe erfolgt erfindungsgemäß durch eine gelenkige Aufhängung des Lötbügelhalters mit einem mittig in der Ebene zwischen den Arbeitsflächen liegenden Dreh- und Ausgleichszentrum.

Der Erfindung liegt die Erkenntnis zugrunde, daß eine gelenkige Aufhängung des Lötbügelhalters dann einen optimalen Parallelitätsausgleich zwischen zwei oder vier Arbeitsflächen und der Leiterplatte ermöglicht, wenn die hierzu erforderlichen Dreh- bzw. Schwenkbewegungen um ein ausgelagertes, mittig in der Ebene zwischen den Arbeitsflächen liegendes Dreh- und Ausgleichszentrum vorgenommen werden. Nur bei eiher derartigen Lage des Dreh- und Ausgleichszentrums können beim Ausetzen der Lötvorrichtung auf die Lötstelle unerwünschte und schädliche Kraftübertragungen in Richtung der Leiterplattenebene vermieden werden. Beim Aufsetzen auf die Lötstelle werden für den Parallelitätsausgleich allenfalls geringe Normalkräfte auf die Leiterplatte übertragen. Der für den Lötvorgang erforderliche höhere Druck wird dann erst nach dem Parallelitätsausgleich, d.h. ausschließlich als Normalkraft aufgebracht.

Gemäß einer bevorzugten Ausgestaltung der Erfindung sind die Auslenkungen des Lötbügelhalters um das Dreh- und Ausgleichszentrum zumindest weitgehend frei von Rückstellkräften. Hierdurch kann eine durch den Parallelitätsausgleich bedingte Kraftübertragung auf die Leiterplatte praktisch vollständig vermieden werden.

Gemäß einer weiteren bevorzugten Ausgestaltung der Erfindung ist die gelenkige Aufhängung zur Feststellung einer ausgelenkten Stellung des Lötbügelhalters verriegelbar. Durch eine derartige Verriegelung kann dann beispielsweise bei einer Schiefstellung einer Leiterplatte der für die erste Lötung vorgenommene Parallelitätsausgleich für die nachfolgenden Lötungen beibehalten werden.

Schließlich hat sich eine der gelenkigen Aufhängung zugeordnete Verdrehsicherung zur Verhinderung von Drehungen um eine senkrecht zu den Arbeitsflächen verlaufende Achse als äußerst vorteilhaft erwiesen. Durch eine derartige Verdrehsicherung können beispielsweise durch Kabelzuleitungen, durch Massenkräfte beim Verfahren der Lötvorrichtung oder auch durch unbeabsichtigte Kollisionen hervorgerufene Verdrehungen der Arbeitsflächen in der Leiterplattenebene und relativ zur Lötstelle mit Sicherheit ausgeschlossen werden. Die gelenkige Aufhängung des Lötbügelhalters hat dann nur noch den Freiheitsgrad 2 mit zwei zur Leiterplattenebene senkrechten Drehungen.

Ausführungsbeispiele der Erfindung sind in der Zeichnung dargestellt und werden im folgenden näher beschrieben.

Es zeigen
- Fig. 1: das stark vereinfachte Grundprinzip einer erfindungsgemäßen Lötvorrichtung mit vier U-förmigen Flachlötbügeln,
- Fig. 2: eine Draufsicht auf die Arbeitsflächen der Flachlötbügel der in Fig. 1 dargestellten Lötvorrichtung mit einer exakten Definition der Lage des Dreh- und Ausgleichszentrums,
- Fig. 3: den Parallelitätsausgleich der in den Fig. 1 und 2 dargestellten Lötvorrichtung im Falle einer Schiefstellung der Leiterplatte und
- Fig. 4: eine Variante der in den Fig. 1 bis 3 dargestellten Lötvorrichtung mit einer zusätzlichen Verdrehsicherung.

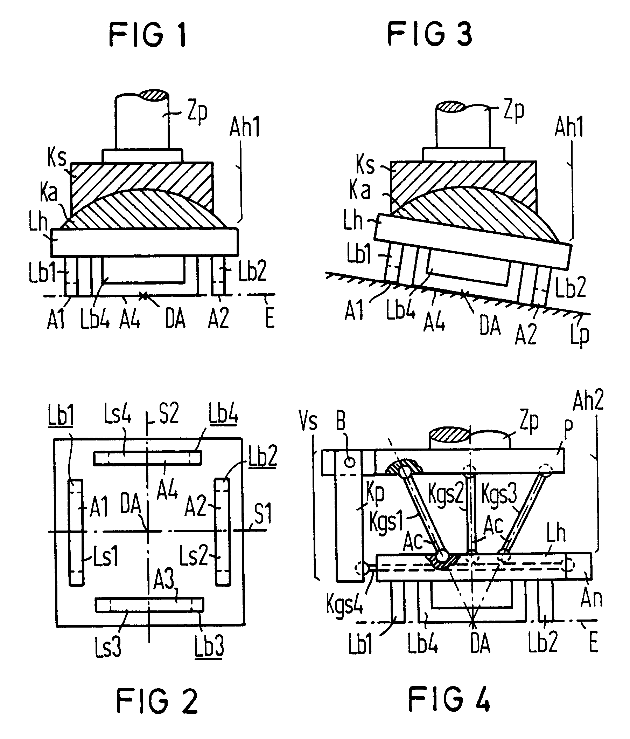

Fig. 1 zeigt in stark vereinfachter schematischer Darstellung das Grundprinzip einer erfindungsgemäßen Vorrichtung, wobei die zum Verständnis der Erfindung nicht erforderlichen Teile wie Stromzuführungen und dergleichen weggelassen wurden. Die dargestellte Lötvorrichtung besitzt vier an einem Lötbügelhalter Lh befestigte U-förmige Flachlötbügel Lb1, Lb2, Lb3 und Lb4, wobei die zugehörigen Lötstege mit Ls1, Ls2, Ls3 und Ls4 und vier zugeordnete Arbeitsflächen auf der Unterseite der Lötstege mit A1, A2, A3 und A4 bezeichnet sind. Insbesondere aus Fig. 2 ist ersichtlich, daß die Lötstege Ls1 und Ls2 parallel im Abstand zueinander ausgerichtet sind. Die Lötstege Ls3 und Ls4 sind ebenfalls parallel im Abstand zueinander ausgerichtet, so daß die in einer mit E bezeichneten Ebene liegenden Arbeitsflächen A1, A2, A3 und A4 einen Rahmen bilden, der im dargestellten Ausführungsbeispiel quadratisch und in den Eckbereichen nicht geschlossen ist.

Der Lötbügelhalter Lh wird über einen Zapfen Zp in einer in der Zeichnung nicht dargestellten Transportvorrichtung aufgenommen, die in drei zueinander senkrechten Richtungen verfahrbar ist und dementsprechend eine Positionierung über der jeweiligen Lötstelle und ein Absenken auf die jeweilige Lötstelle ermöglicht. Der Lötbügelhalter Lh ist über eine gelenkige Aufhängung Ah1 mit dem Zapfen Zp derart verbunden, daß der Lötbügelhalter Lh mit den Flachlötbügeln Lb1 bis Lb4 um ein in Fig. 1 und Fig. 2 mit DH bezeichnetes Dreh- und Ausgleichszentrum bewegt werden kann. Dieses Dreh- und Ausgleichszentrum DA liegt in der Ebene E der Arbeitsflächen A1 bis A4 genau in der Mitte zwischen diesen Arbeitsflächen A1 bis A4, wobei diese mittige Lage in Fig. 2 durch die beiden Symmetrieachsen S1 und S2 verdeutlicht ist.

Die in Fig. 1 lediglich schematisch aufgezeigte gelenkige Aufhängung Ah1 umfaßt einen mit dem Lötbügelhalter Lh verbundenen Kugelabschnitt Ka und eine mit dem Zapfen Zp verbundene Kugelschale Ks, wobei die Mittelpunkte von Kugelabschnitt Ka und Kugelschale Ks genau im Dreh- und Ausgleichszentrum DA liegen. Die gelenkige Aufhängung Ah1 sollte Dreh- bzw. Ausgleichsbewegungen und das Dreh- und Ausgleichszentrum DA ermöglichen, die zumindest weitgehend frei von Rückstellkräften sind. Dies kann man sich bei der schematischen Darstellung gemäß Fig. 1 beispielsweise dadurch vorstellen, daß der Zusammenhalt zwischen Kugelabschnitt Ka und Kugelschale Ks durch eine gegenseitige magnetische Anziehung gewährleistet ist.

Fig. 3 zeigt die Wirkungsweise der in Fig. 1 und 2 dargestellten Lötvorrichtung beim Aufsetzen auf eine schiefgestellte Leiterplatte Lp. Dabei wurde die Schiefstellung der Leiterplatte Lp zur Verdeutlichung des Prinzips stark übertrieben. Beim Aufsetzen wird der Flachlötbügel Lb1, dessen äußere Unterkante zunächst die Leiterplatte Lp berührt um das Dreh- und Ausgleichszentrum DA nach oben geschwenkt bis die Arbeitsflächen A1 bis A4 parallel zur Leiterplatte ausgerichtet sind. Es ist ersichtlich, daß durch die Beweglichkeit um das Dreh- und Ausgleichszentrum DA nicht nur im dargestellten Fall sondern auch bei Leiterplattenwölbungen, bei Leiterplattentoleranzen senkrecht zur Plattenebene oder bei Schichtdickentoleranzen ein optimaler Kontakt der Flachlötbügel Lb1 bis Lb4 mit der Lötstelle realisiert werden kann.

Fig. 4 zeigt eine Variante, bei welcher der Lötbügelhalter Lh über eine mit Ah2 bezeichnete gelenkige Aufhängung mit dem Zapfen Zp verbunden ist. Die gelenkige Aufhängung Ah2 umfaßt drei Kugelgelenkstäbe Kgs1 bis Kgs3, deren Enden in nicht näher bezeichneten Kugelschalen einer mit dem Zapfen verbundenen Platte P bzw. des Lötbügelhalters Lh angeordnet sind. Die in der Projektion jeweils Winkel von 120° zwischen sich einschließenden Achsen Ac der Kugelgelenkstäbe Kgs1 bis Kgs3 müssen dabei so ausgerichtet sein, daß ihr in Fig. 4 dargestellter Schnittpunkt genau im Dreh- und Ausgleichszentrum DA liegt. Eine mit Vs bezeichnete Verdrehsicherung verhindert Drehungen des Lötbügelhalters Lh in der Ebene E. Diese Verdrehsicherung umfaßt eine in einer gabelförmigen Ausnehmung der Platte P um einen Bolzen B drehbare Klappe Kp, deren unteres Ende über zwei Kugelgelenkstäbe Kgs4 an zugeordnete Ansätze An des Lötbügelhalters Lh angelenkt ist. In der in Fig. 4 dargestellten Lage sind die beiden Kugelgelenkstäbe Kgs4 parallel zur Zeichnungsebene vor und hinter dem Lötbügelhalter Lh angeordnet. Die dargestellte Verdrehsicherung Vs ermöglicht einerseits die erwünschten Ausgleichsbewegungen um das Dreh- und Ausgleichszentrum DA und verhindert andererseits die unerwünschten Drehbewegungen um eine zur Ebene E senkrechte Achse. Letztere würden eine genaue Orientierung der Flachlötbügel Lb1 bis Lb4 relativ zu den Anschlußkonfigurationen der aufzulötenden Bauelemente verhindern. Eine solche Verdrehsicherung wäre daher auch für die in den Figuren 1 bis 3 dargestellte Ausführungsform von Vorteil.

Neben den beschriebenen Ausführungsbeispielen kann die Erfindung auch mit Hilfe von sog. RCC-Teilen (Remote Center Compliance Devices) realisiert werden, an welchen die Lötbügelhalter herkömmlicher Lötvorrichtungen befestigt werden. Dabei ist lediglich darauf zu achten, daß das ausgelagerte Ausgleichszentrum dieser RCC-Teile genau mittig in der Ebene zwischen den Arbeitsflächen der Lötvorrichtung liegt. Vorhandene Rotationssperren dieser RCC-Teile können dann auch als Verdrehsicherung herangezogen werden. Die geschilderten RCC-Teile werden beispielsweise als Orientierungs- und Fügehilfen für Montagemaschinen oder Roboter vertrieben.

## Patentansprüche

1. Lötvorrichtung mit mindestens einer an einem Lötbügelhalter (Lh) befestigten und durch elektrische Widerstandswärme erhitzbaren Bügelelektrode (B1,B2,B3,B4) und zwei einander gegenüberliegenden Lötstegen oder vier paarweise einander gegenüberliegenden Lötstegen (Ls1,Ls2,Ls3,Ls4), deren Arbeitsflächen (A1,A2,A3,A4) in einer Ebene (E) liegen,
**gekennzeichnet durch**
eine gelenkige Aufhängung (Ah1;Ah2) des Lötbügelhalters (Lh) mit einem mittig in der Ebene (E) zwischen den Arbeitsflächen (A1,A2,A3,A4) liegenden Dreh- und Ausgleichszentrum (DA).

2. Lötvorrichtung nach Anspruch 1,
**dadurch gekennzeichnet,**
daß die Auslenkungen des Lötbügelhalters (Lh) um das Dreh- und Ausgleichszentrum (DA) zumindest weitgehend frei von Rückstellkräften sind.

3. Lötvorrichtung nach Anspruch 1 oder 2,
**dadurch gekennzeichnet,**
daß die gelenkige Aufhängung (Ah1;Ah2) zur Feststellung einer ausgelenkten Stellung des Lötbügelhalters (Lh) verriegelbar ist.

4. Lötvorrichtung nach einem der vorhergehenden Ansprüche,
**gekennzeichnet durch**
eine der gelenkigen Aufhängung (Ah2) zugeordnete Verdrehsicherung (Vs) zur Verhinderung von Drehungen um eine senkrecht zu den Arbeitsflächen (A1,A2,A3,A4) verlaufende Achse.

## Claims

1. Soldering device with at least one stirrup electrode (B1, B2, B3, B4), which is fastened to a soldering stirrup holder (Lh) and can be heated by electrical resistance heat, and with two soldering bridges opposite each other or four soldering bridges (Ls1, Ls2, Ls3, Ls4), opposite each other in pairs, the working surfaces (A1, A2, A3, A4) of which bridges lie in a plane (E), characterised by an articulated suspension (Ah1; Ah2) of the soldering stirrup holder (Lh) with a pivoting and compensating centre (DA) lying centrally in the plane (E) between the working surfaces (A1, A2, A3, A4).

2. Soldering device according to Claim 1, characterised in that the deflections of the soldering stirrup holder (Lh) about the pivoting and compensating centre (DA) are, at least to a great extent, free from restoring forces.

3. Soldering device according to Claim 1 or 2, characterised in that the articulated suspension (Ah1; Ah2) is lockable for fixing a deflected position of the soldering stirrup holder (Lh).

4. Soldering device according to one of the preceding claims, characterised by an anti-twisting means (Vs), assigned to the articulated suspension (Ah2), for preventing twists about an axis running perpendicularly with respect to the working surfaces (A1, A2, A3, A4).

## Revendications

1. Dispositif de soudage comportant au moins une électrode en forme d'étrier (B1, B2, B3, B4), fixée à un support d'étrier de soudure (Lh) et chauffée par effet Joule, et deux barrettes de soudure situées l'une en face de l'autre ou quatre barrettes de soudure se faisant face par paires (Ls1, Ls2, Ls3, Ls4), dont les surfaces de travail (A1, A2, A3, A4) se situent dans un plan (E), caractérisé par une suspension articulée (Ah1; Ah2) du support d'étrier de soudure (Lh), présentant un centre de rotation et de compensation (DA) qui se situe au centre du plan (E), entre les surfaces de travail (A1, A2, A3, A4).

2. Dispositif de soudage selon la revendication 1, caractérisé par le fait que les débattements du support d'étrier de soudure (Lh) sont très largement dépourvus de forces de rappel autour du centre de rotation et de compensation (DA).

3. Dispositif de soudage selon la revendication 1 ou 2, caractérisé par le fait que la suspension articulée (Ah1; Ah2) est susceptible d'être verrouillée pour fixer une position de débattement du support d'étrier de soudage (Lh).

4. Dispositif de soudage selon l'une des revendications précédentes, caractérisé par un dispositif de sécurité contre une rotation (Vs), associé à la suspension articulée (Ah2) et servant à empêcher des rotations autour d'un axe perpendiculaire aux surfaces de travail (A1, A2, A3, A4).
